Europäisches Patentamt

European Patent Office

Office européen des brevets

(19)

(11) Numéro de publication : **0 119 502**
**B1**

(12) **FASCICULE DE BREVET EUROPÉEN**

(45) Date de publication du fascicule du brevet :
28.05.86

(51) Int. Cl.⁴ : **F 25 B 21/02, H 01 L 35/30**

(21) Numéro de dépôt : **84101783.3**

(22) Date de dépôt : **21.02.84**

(54) **Installation thermoélectrique.**

(30) Priorité : **17.03.83 FR 8304541**

(43) Date de publication de la demande :
**26.09.84 Bulletin 84/39**

(45) Mention de la délivrance du brevet :
**28.05.86 Bulletin 86/22**

(84) Etats contractants désignés :
**CH DE GB IT LI NL SE**

(56) Documents cités :
**EP-A- 0 017 083**
**EP-A- 0 017 084**
**EP-A- 0 055 175**
**FR-A- 1 430 425**
**FR-A- 1 541 999**
**FR-A- 1 547 908**
**FR-A- 2 315 771**
**FR-A- 2 322 459**
**FR-A- 2 419 479**
**FR-A- 2 463 372**
**FR-A- 2 481 786**
**US-A- 3 178 894**

(73) Titulaire : **AIR INDUSTRIE**
**19, avenue Dubonnet**
**F-92400 Courbevoie (FR)**

(72) Inventeur : **Benicourt, Michel**
**18 rue Montbauron**
**F-78000 Versailles (FR)**
Inventeur : **Buffet, Jean**
**2 Avenue Dode de Brunerie**
**F-75016 Paris (FR)**
Inventeur : **Huard, Jean-François**
**1 pré Hayer**
**F-54700 Pont.A.Mousson (FR)**

(74) Mandataire : **Puit, Thierry et al**
**c/o Centre de Recherches de Pont-à-Mousson B.P. 28**
**F-54703 Pont-à-Mousson Cedex (FR)**

Jouve, 18, rue St-Denis, 75001 Paris, France

## Description

L'invention est relative, d'une façon générale, aux installations thermoélectriques comportant des thermoéléments (ou éléments thermoélectriques) montés entre des parois d'échange thermique appartenant à des échangeurs chauds parcourus par un fluide chaud et à des échangeurs froids parcourus par un fluide froid.

De telles installations peuvent être utilisées pour engendrer un courant électrique continu lorsque les parois d'échange thermique sont maintenues à des températures différentes par le fluide chaud et le fluide froid, ou, au contraire, pour maintenir les parois d'échange thermique à des températures différentes en vue de chauffer ou de refroidir un fluide par rapport à l'autre lorsqu'on fait circuler un courant électrique dans les thermoéléments. Le courant électrique est généralement amené aux thermoéléments par les échangeurs, toutefois, dans le cas d'utilisation de modules thermoélectriques, le courant électrique est amené directement aux modules.

L'invention s'applique plus particulièrement, mais non exclusivement, à ces derniers types d'installation, les thermoéléments étant alimentés en courant électrique continu pour entretenir une différence de température entre les parois d'échange thermique. Une telle installation, appelée « pompe à chaleur », peut être utilisée à des fins de climatisation en réchauffant ou en refroidissant un fluide à partir d'un autre fluide. En effet, les thermoéléments sont de deux types, à savoir : les thermoéléments de type P, qui transfèrent des calories dans le sens du courant électrique, et les thermoéléments de type N, qui transfèrent des calories dans le sens inverse du courant. Ainsi, en plaçant un thermoélément de type N et un thermoélément de type P de part et d'autre d'un échangeur thermique, les flux thermiques de même nature (chaleur ou froid) créés par ces thermoéléments convergent vers l'échangeur ou divergent selon le sens du courant.

Il a déjà été proposé que des installations thermoélectriques soient formées d'empilements d'échangeurs chauds et froids alternant avec des thermoéléments, le ou les échangeurs de part et d'autre desquels se trouvent les thermoéléments étant ou non isolés électriquement, ces empilements ou colonnes étant disposés côte à côte de manière à constituer un ensemble compact dans lequel les thermoéléments se trouvent dans des plans parallèles ou nappes et les échangeurs en regard les uns des autres formant des nappes d'échangeurs chauds ou froids afin de constituer des conduits de circulation des fluides à refroidir ou à réchauffer. Les éléments constitutifs de chaque colonne ne sont reliés entre eux que par compression des thermoéléments et des échangeurs d'une même colonne à l'aide de moyens assurant le serrage de plusieurs colonnes à la fois et destinés à assurer de bonnes liaisons électriques entre ces différents éléments tout en facilitant leur montage. De plus, les liaisons électriques entre les colonnes sont réalisées à leurs extrémités.

Une telle disposition est montrée par exemple dans la demande de brevet européen EP-A-0 055 175 (Buffet) où la structure en colonnes composée de thermoéléments et d'échangeurs alternés est nettement visible. Une structure comparable, utilisée pour la réalisation d'une batterie thermoélectrique, est montrée dans la demande de brevet FR-A-2 322 495 (Air Industrie). Les échangeurs enserrant les thermoéléments sont empilés en colonnes serrées selon leur axe. Dans ces deux exemples, l'axe des échangeurs constituant la colonne, coïncide avec l'axe des thermoéléments intercalés coopérant avec lesdits échangeurs.

Dans les installations connues actuellement, les thermoéléments et les échangeurs d'une même colonne sont empilés selon un même axe et sont serrés selon cet axe. Toutefois, en raison des dilatations dues aux flux thermiques, en raison des inégalités d'épaisseur dues aux précisions d'usinage des différents constituants empilés, et afin d'obtenir un alignement des échangeurs d'un même plan de plusieurs colonnes et un bon contact entre les thermoéléments et les échangeurs, lors du serrage, il est nécessaire de créer des efforts de serrage élevés qui ne sont pas acceptables par les thermoéléments dont les caractéristiques mécaniques, en particulier la résistance au cisaillement, sont relativement faibles.

Pour réduire les contraintes sur les thermoéléments créées lors du serrage afin d'obtenir un bon contact entre thermoéléments et échangeurs et un bon alignement entre les échangeurs d'une même nappe, il est connu d'utiliser divers moyens. En particulier, des échangeurs à déformations peuvent être utilisés, toutefois, ces échangeurs sont difficiles à réaliser donc coûteux et ont des caractéristiques de conductions thermique et électrique faibles du fait que certaines parties de ces échangeurs doivent être amincies pour permettre d'obtenir la déformation de ces échangeurs lors du serrage des colonnes.

La demande de brevet européen EP-A-0 017 083 (CEPEM) montre une réalisation d'une pompe à chaleur thermoélectrique eau-air où les échangeurs à eau comportent un tube métallique mince en bon contact thermique avec une boîte déformable permettant de rattraper les inégalités provenant des précisions d'usinage des pièces et d'absorber les dilatations thermiques lors du fonctionnement.

Dans certaines installations connues, il est possible, sans augmenter les contraintes sur les thermoéléments, que les échangeurs d'une même nappe ne soient pas parfaitement alignés, la liaison entre échangeurs devant alors être souple. Cette liaison souple peut être réalisée par des raccords souples et ces raccords sont coûteux, délicats à monter et sources de fuites pour le fluide qu'ils transportent.

L'utilisation de petits soufflets métalliques assurant la continuité du circuit fluide tout en désolidarisant mécaniquement les échangeurs placés sur ce circuit fluide, est montrée dans le brevet américain US-3 178 894 (Mole). Les soufflets autorisent un léger désalignement des échangeurs, permettant ainsi de ne pas transmettre d'efforts mécaniques au niveau des thermoéléments.

Un autre moyen de réaliser une liaison souple entre les échangeurs est que le fluide à refroidir ou à réchauffer circule dans un ou plusieurs tubes ou conduits traversant les échangeurs d'une même nappe. Toutefois, pour que la liaison soit souple entre ces échangeurs, il faut que ces tubes soient eux-mêmes souples. Dans ce cas, la pression de contact entre ce tube et les échangeurs, pression donnée par le fluide transporté, doit être élevée pour obtenir une résistance thermique de contact la plus faible possible entre les échangeurs et le tube, ce qui rend complexes, les jonctions entre tubes d'une même nappe et/ou de plusieurs nappes.

La présente invention a pour but de remédier à ces inconvénients tout en permettant une liaison rigide entre les échangeurs d'une même nappe. Elle a pour objet une installation thermoélectrique comportant des thermoéléments montés entre des échangeurs de chaleur, munis d'un conduit de circulation d'un fluide chaud ou d'un fluide froid et alternant avec les thermoéléments pour former des empilements ou colonnes disposés côte à côte de manière à réaliser un ensemble ou tiroir dans lequel les thermoéléments se trouvent dans des plans parallèles et les échangeurs en regard les uns des autres, sous forme de nappes délimitant deux conduits de circulation des fluides, l'un pour le fluide chaud, l'autre pour le fluide froid, les éléments constitutifs de chaque colonne étant maintenus ensemble par des moyens de serrage.

Cette installation est notamment remarquable par le fait que, les conduits de circulation des fluides chaud ou froid des échangeurs étant situés en dehors de l'axe de serrage des empilements, les échangeurs adjacents d'une même nappe peuvent tourner l'un par rapport à l'autre autour de l'axe de leur conduit de circulation, les thermoéléments et les échangeurs étant en contact selon l'axe de serrage des empilements, leurs contacts sur au moins une de leurs faces ayant un profil permettant une rotation par rapport à l'axe des conduits de circulation.

Ainsi, lors du serrage des éléments constitutifs de plusieurs colonnes situées côte à côte, il se produira une rotation des échangeurs autour de l'axe du conduit qu'ils forment jusqu'à ce que les éléments constitutifs de chaque colonne soient bien en appui les uns sur les autres, les conduits formés par tous les échangeurs d'une même nappe créant ainsi un conduit unique continu de circulation des fluides.

Le profil des contacts entre échangeurs et thermoéléments peut être un profil cylindrique d'axe parallèle à l'axe des conduits de circulation et passant par l'axe de serrage de l'empilement.

De même, le profil de contacts entre échangeurs et thermoéléments peut être un profil sphérique dont le centre est situé sur l'axe de serrage des empilements.

Grâce aux contacts cylindriques ou sphériques entre chaque échangeur et thermoélément, cette rotation est réalisée sans créer d'efforts de cisaillement dans les thermoéléments.

Une installation selon l'invention peut comporter des échangeurs de chaleur formés chacun d'une âme située, en contact, entre les thermoéléments et percée d'un conduit décalé par rapport à l'axe de serrage des empilements et de même axe que le conduit d'un échangeur de la colonne voisine, conduits dans lesquels est serti un tube rigide isolant électrique ou isolé électriquement des échangeurs, les échangeurs pouvant tourner par rapport au tube.

Ainsi, tout déplacement de l'échangeur sous l'effet de l'effort de serrage se traduit par une rotation autour du tube rigide, le contact sphérique entre échangeurs et thermoéléments permettant cette rotation sans créer de force de cisaillement destructrice des thermoéléments.

D'autres caractéristiques et avantages apparaîtront au cours de la description qui va suivre.

Aux dessins annexés donnés uniquement à titre d'exemple :

la Fig. 1 est une vue schématique en élévation d'une installation thermoélectrique selon l'invention ;

la Fig. 2 est une vue schématique en coupe selon la ligne 2-2 de la Fig. 1 d'une installation thermoélectrique selon l'invention ;

la Fig. 3 est une vue schématique partielle éclatée en perspective et à plus grande échelle que les Fig. 1 et 2 d'une installation thermoélectrique selon l'invention ;

la Fig. 4 est une vue schématique partielle du même type que la Fig. 3 d'une variante d'installation thermoélectrique selon l'invention ;

la Fig. 5 est une vue schématique partielle en coupe d'une autre variante d'installation thermoélectrique selon l'invention ;

la Fig. 6 est une vue schématique partielle en coupe d'une autre variante d'installation thermoélectrique selon l'invention.

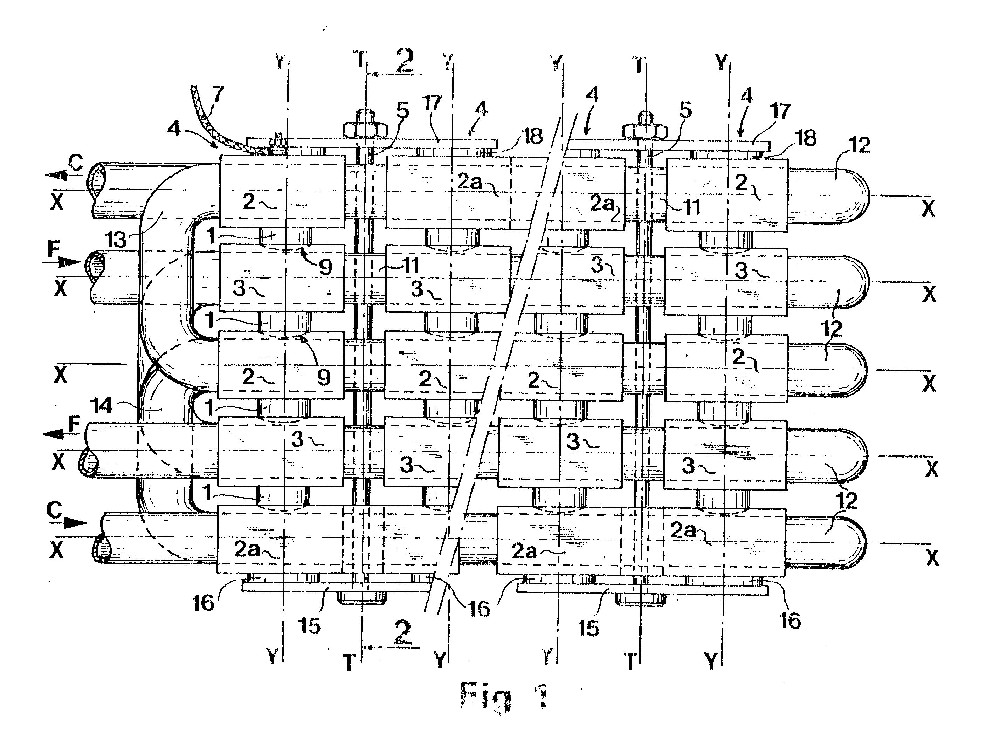

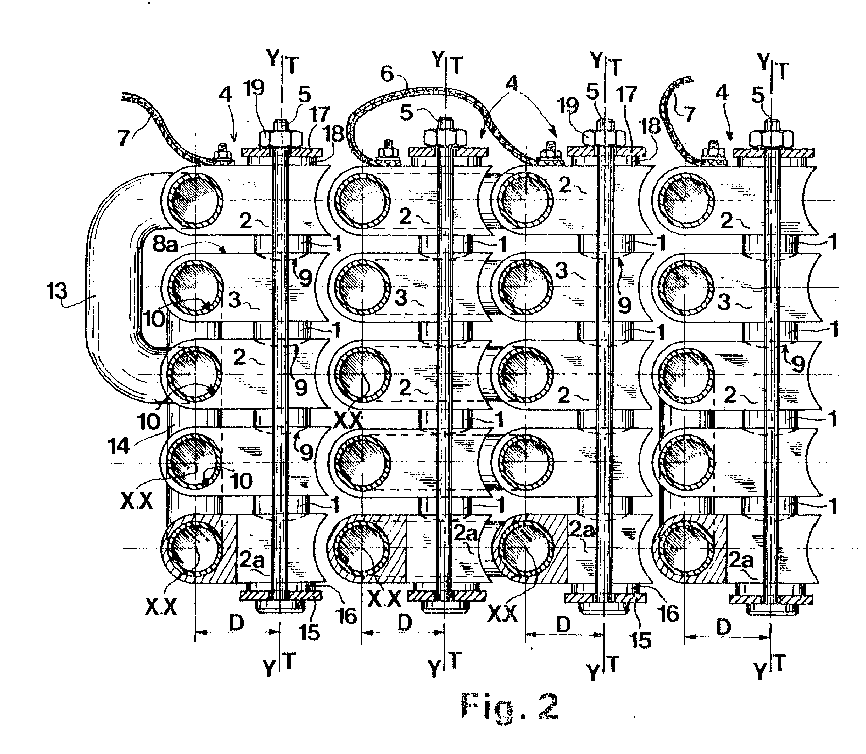

Suivant l'exemple d'exécution représenté aux Fig. 1 à 3, une installation thermoélectrique du type « pompe à chaleur » selon la présente invention comporte des thermoéléments ou éléments thermoélectriques 1 alimentés en courant électrique continu pour entretenir une différence de température entre des échangeurs thermiques 2 et 3 situés de part et d'autre de chaque thermoélément 1.

Ces échangeurs thermiques 2 et 3 sont des échangeurs chauds lorsqu'ils sont parcourus par un fluide chaud ou à réchauffer et des échangeurs froids lorsqu'ils sont parcourus par un fluide froid ou à refroidir. Les sens de circulation de ces fluides chaud et froid étant repérés sur la Fig. 1 par des flèches respectivement C et F.

Les échangeurs thermiques 2 et 3 sont empilés alternativement avec les thermoéléments 1 pour former des colonnes 4. Ces colonnes disposées côte à côte et assemblées entre elles constituent un ensemble ou tiroir thermoélectrique où les thermoéléments se trouvent dans des plans parallèles et les échangeurs en regard les uns des autres en forme de nappes. Les échangeurs et thermoéléments sont assemblés entre eux par des tirants 5 d'axe TT parallèle aux colonnes 4, chaque tirant 5 assurant le serrage, dans l'exemple représenté non limitatif, de deux colonnes adjacentes.

Les thermoéléments 1 n'étant pas isolés électriquement des échangeurs 2 et 3, dans chaque colonne, la liaison électrique des thermoéléments d'une même colonne, entre eux, se fait au travers des échangeurs suivant un parcours rectiligne ; le passage du courant électrique entre deux colonnes adjacentes est réalisé soit par des échangeurs doubles 2a, obtenus par solidarisation de deux échangeurs voisins, soit par des conducteurs 6, souples ou non, fixés sur les deux échangeurs 2 d'extrémité des colonnes adjacentes. Le courant électrique est amené à l'ensemble de l'installation par les conducteurs d'entrée et de sortie 7 fixés à deux échangeurs 2.

Selon l'invention, chaque thermoélément 1 a la forme d'une pastille cylindrique pourvue d'une face plane et d'une face à profil sphérique. Chaque échangeur 2 et 3 est formé d'une âme 8 sensiblement parallélépipédique dont l'une des faces 8a est pourvue d'une cuvette 9, à profil sphérique conjuguée de la face à profil sphérique d'un thermoélément 1 avec laquelle elle doit venir en contact. Chaque échangeur est percé d'un conduit 10 à section circulaire d'axe XX parallèle à la face 8a de l'âme 8, et décalé d'une distance D de la normale YY à cette face 8a, au centre de la cuvette 9.

A l'intérieur des conduits 10 d'une même nappe, et donc de même axe XX, est serti un tube 11, rigide, si possible bon conducteur de la chaleur. Ce sertissage est tel que, sous l'effet d'un certain effort, l'âme 8 peut tourner autour du tube 11. Dans le cas où le tube rigide 11 est un matériau conducteur de l'électricité, tel que du cuivre ou autre métal, il est interposé, avant sertissage, entre le tube 11 et le conduit 10, un matériau isolant électrique tel qu'un film de polyester 20, ce film facilite la rotation de l'âme 8 autour du tube 11. Les tubes 11 d'une même nappe d'échangeurs 2 ou 3 sont reliés entre eux aux extrémités par des coudes 12 de manière à former un circuit continu d'écoulement des fluides. Dans l'exemple représenté, à quatre nappes de thermoéléments 1 et, par conséquent, à cinq nappes d'échangeurs 2 et 3, les tubes 11 des nappes d'échangeurs 2 sont reliés entre eux par des coudes 13 pour former un circuit unique de circulation d'un des fluides, tel que le fluide chaud, circulant selon les flèches C. De même, les tubes 11 des nappes d'échangeurs 3 sont reliés entre eux par des coudes 14 pour former un circuit unique de circulation de l'autre fluide, tels que le fluide froid, circulant selon les flèches F. Par la présence des coudes 14 et 13, les tubes 11 sont liés rigidement les uns aux autres.

Le montage de l'installation thermoélectrique se fait de la manière suivante :

Chaque nappe d'échangeurs étant formée avec les tubes 11 et les coudes 12 de liaison des tubes d'une même nappe, on empile ces nappes les unes au-dessus des autres en interposant dans les cuvettes 9 des échangeurs les thermoéléments sur lesquels vient s'appliquer la nappe d'échangeurs immédiatement supérieure. Lorsque l'empilement de l'ensemble des nappes d'échangeurs et de thermoéléments, quatre thermo-éléments et cinq échangeurs par colonne dans l'exemple représenté, est réalisé, chaque tirant 5, solidaire d'une plaque d'appui 15 et de plots cylindriques 16 isolants électriques, est introduit, en traversant les nappes d'échangeurs entre deux échangeurs adjacents d'une même nappe et portés par le même tube, la plaque d'appui 15 venant s'appliquer par les plots cylindriques 16 sous les échangeurs de la nappe inférieure selon l'axe YY d'empilement des colonnes à serrer. Une plaque de serrage 17 traversée par le tirant 5 vient s'appliquer par des plots cylindriques 18 isolants électriques sur les échangeurs des colonnes correspondantes de la nappe supérieure, un écrou 19, vissé sur le tirant 5, venant assurer le serrage des différentes nappes entre elles. Après serrage, les coudes 13 et 14 sont solidarisés aux tubes, par exemple par soudure, pour assurer la continuité de circulation des fluides chauds et froids.

Sous l'action du serrage du tirant 5, selon l'axe TT parallèle aux axes YY des colonnes, les âmes 8 des échangeurs et les thermoéléments 1 correspondants d'une même colonne sont serrés entre eux. En raison des différences dimensionnelles pouvant intervenir lors de la fabrication des différents éléments, les colonnes peuvent avoir des hauteurs différentes et les âmes des échangeurs d'une même nappe peuvent ne pas être situées parfaitement dans un même plan. Comme les tubes 11 et les coudes 12 reliant les échangeurs d'une même nappe sont rigides, et comme le serrage des colonnes par les tirants est réalisé selon les axes YY, décalés d'une distance D des axes XX correspondants des tubes 11, il se produit une rotation autour des axes XX des âmes 8 des échangeurs par rapport aux tubes 11 qui permet d'obtenir un serrage correct des colonnes malgré ces différences dimensionnelles. Ce serrage étant réalisé sans créer de déformation des tubes entre les échangeurs ni de destruction des thermoéléments situés entre ces échangeurs. Les cuvettes 9 des âmes 8 des échangeurs et les faces sphériques d'appui des thermoéléments dans les cuvettes 9 permettent la rotation de l'âme 8 tout en assurant un bon contact des thermoéléments sur les échangeurs, sans destruction des thermoéléments par le cisaillement créé lors de la rotation de l'âme 8.

Ainsi, grâce à l'invention, il est possible de réaliser une installation thermoélectrique comportant des tubes de circulation des fluides chauds et froids sans risques de fuites entre échangeurs puisque comportant des tubes 11 rigides et continus et ayant une bonne conduction électrique et thermique entre échangeurs et thermoéléments. Cette bonne conduction électrique et thermique est obtenue grâce au serrage important qui peut être réalisé entre les thermoéléments et les échangeurs par les tirants, et ce malgré les différences dimensionnelles créées, lors de leur empilement. Ces caractéristiques sont permises par l'utilisation de la rotation des échangeurs par rapport aux tubes 11 et par les contacts sphériques entre échangeurs et thermoéléments.

Les échangeurs et les thermoéléments étant uniquement en contact par au moins une surface à profil sphérique sans liaison rigide entre eux, ce contact permet les dilatations thermiques différentielles entre les échangeurs d'une même nappe.

La présence d'un film 20 isolant électrique entre les tubes 11 et les conduits 10 des âmes 8 des échangeurs 2 et 3, tout en assurant l'isolation électrique sans augmenter de manière sensible la résistance thermique entre les échangeurs 2 et 3 et les tubes 11, facilite, lorsque ce film est lisse, la rotation des âmes 8 par rapport aux tubes 11 donc le serrage des colonnes par les tirants 5.

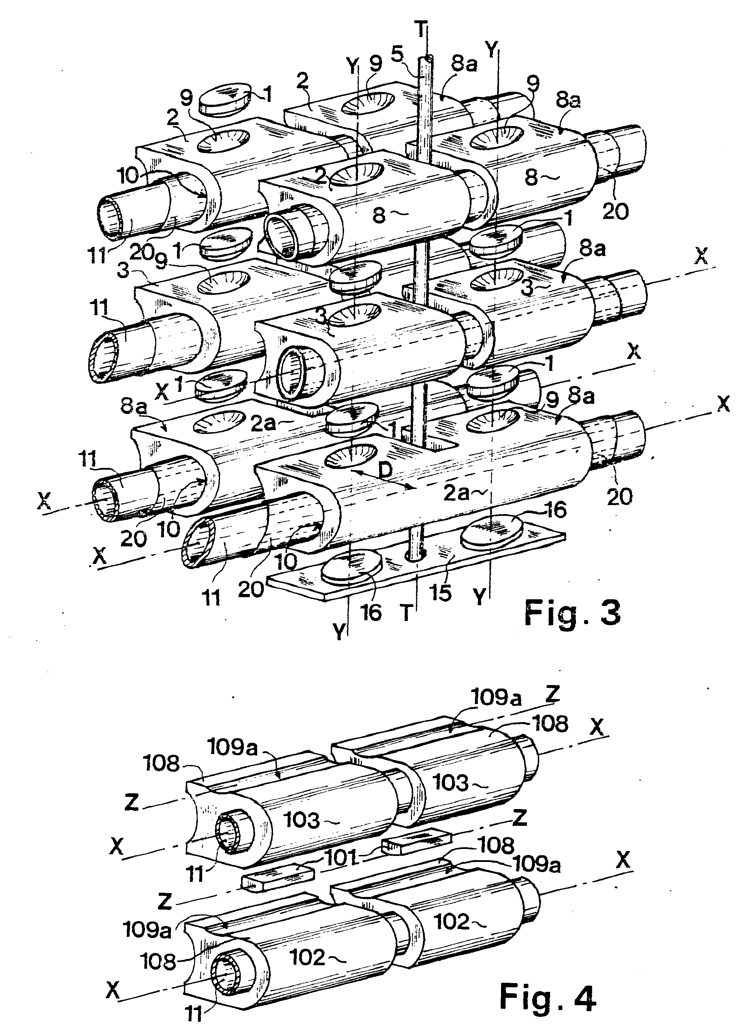

Suivant une variante de réalisation représentée à la Fig. 4, les échangeurs 102-103 et les thermoéléments 101 peuvent être en contact par au moins une surface à profil cylindrique d'axe ZZ parallèle à l'axe XX des conduits de circulation des échangeurs, l'axe ZZ de la surface passant par l'axe YY de serrage des thermoéléments. Dans ce cas, les cuvettes 109a des âmes 108 et les faces d'appui correspondantes des thermoéléments ont un profil cylindrique. Ce profil cylindrique permet, comme pour le profil sphérique, la rotation des échangeurs entre eux et les dilatations thermiques différentielles.

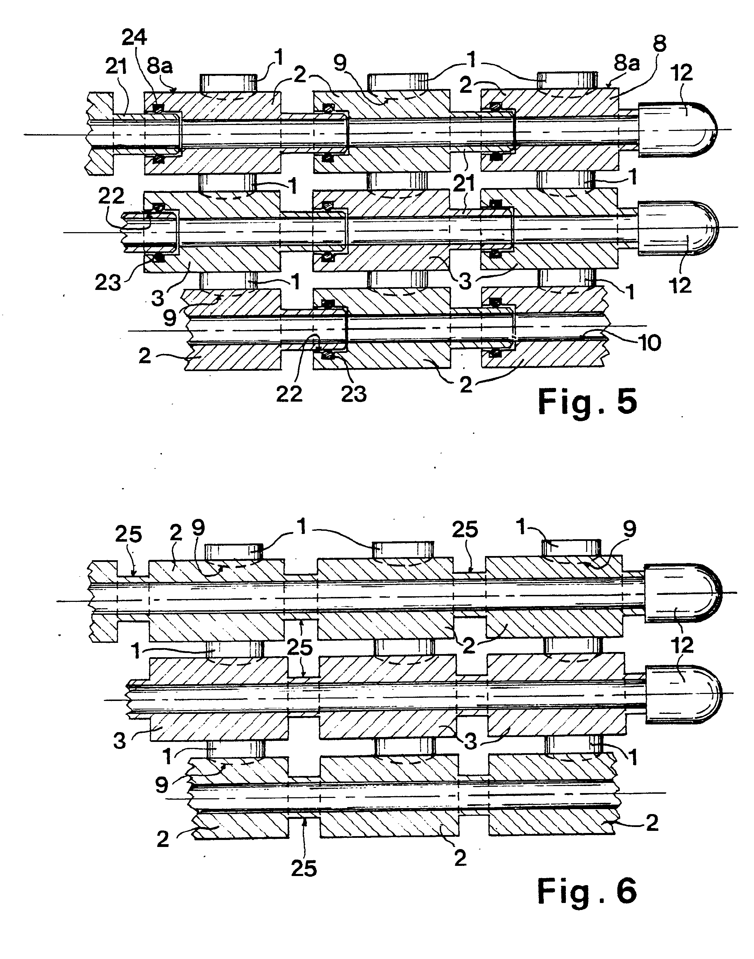

Suivant une variante de réalisation représentée à la Fig. 5, l'installation thermoélectrique comporte des colonnes formées par empilement de thermoéléments 1 et d'échangeurs 2 et 3 formés d'une âme 8 pourvue d'un conduit 10. Ce conduit 10 comporte, d'un côté, un prolongement tubulaire 21 et, de l'autre côté, une chambre 22 circulaire interne au conduit 10 formant emboîtement pour le prolongement tubulaire de l'échangeur adjacent, cette chambre étant munie d'une gorge annulaire 23 circonférentielle renfermant un joint d'étanchéité. Les échangeurs d'une même nappe sont alors emboîtés les uns dans les autres pour former un tube de circulation des fluides. La liaison par emboîtement avec joint d'étanchéité 24 permet aux échangeurs, lors du serrage des tirants, d'effectuer une rotation les uns par rapport aux autres selon l'axe XX du conduit 10 tout en conservant la continuité des tubes de circulation des fluides.

Pour assurer l'isolation électrique entre échangeurs de colonnes différentes, les prolongements tubulaires 21 peuvent être recouverts sur leur face externe et leur extrémité par un revêtement isolant tel qu'une peinture isolante ou par une coiffe en un film de matière isolante, en polyester par exemple. Dans une telle réalisation, il est souhaitable que les fluides soient mauvais conducteurs de l'électricité ou que les conduits 10 présentent un revêtement intérieur isolant.

Alors que dans les exemples de réalisation décrits ci-dessus, les thermoéléments ont la forme d'une pastille cylindrique ou parallélépipédique pourvue d'une face plane et d'une face sphérique ou cylindrique, ils peuvent avoir deux faces sphériques ou cylindriques ou être formés de deux faces planes sur lesquelles sont rapportées par soudure deux plaques, l'une au moins ayant une face sphérique ou cylindrique destinée à venir se placer dans les cuvettes 9 des échangeurs 2 et 3 de forme correspondante.

De plus, il est possible que ce soient les thermoéléments qui présentent les cuvettes sphériques ou cylindriques et que les échangeurs présentent des bossages du profil correspondant à celui des thermoéléments.

Il est également possible de remplacer chaque thermoélément par un module thermoélectrique, formé de plusieurs thermoéléments, sur lequel est rapportée au moins une plaque ayant une face à profil cylindrique ou sphérique. L'alimentation électrique des modules thermoélectriques est réalisée à la manière connue, chaque module thermoélectrique étant isolé électriquement des échangeurs. Dans ce cas, il n'est plus nécessaire d'assurer l'isolement électrique entre les échangeurs adjacents puisqu'ils ne sont plus sous tension, et, en particulier, entre les échangeurs et les tubes de circulation.

L'utilisation de modules thermoélectriques dans la variante de réalisation ci-dessus représentée à la Fig. 5 permet de supprimer le revêtement isolant des prolongements tubulaires 21. Les fluides peuvent être conducteurs de l'électricité puisque les échangeurs ne sont plus sous tension.

En utilisant des modules thermoélectriques, une autre variante de réalisation, représentée à la Fig. 6, consiste en ce que les échangeurs d'une même nappe formant un seul conduit sont en une seule pièce, des zones amincies 25 étant réalisées entre chaque échangeur de manière que ces zones amincies permettent la rotation des échangeurs entre eux par déformation de la matière ductile les constituant dans ces zones amincies.

**Revendications**

1. Installation thermoélectrique comportant des thermoéléments (1, 101) montés entre des échangeurs de chaleur (2-3, 102-103), munis d'un conduit (10) de circulation d'un fluide chaud (C) ou d'un fluide froid (F) et alternant avec les thermoéléments pour former des empilements ou colonnes (4) disposés côte à côte de manière à réaliser un ensemble ou tiroir dans lequel les thermoéléments se trouvent dans des plans parallèles et les échangeurs en regard les uns des autres sous forme de nappes, délimitant deux conduits de circulation des fluides, l'un pour le fluide chaud, l'autre pour le fluide froid, les éléments constitutifs de chaque colonne étant maintenus ensemble par des moyens de serrage (5), caractérisée en ce que, les conduits (10) de circulation des fluides chauds ou froids des échangeurs étant situés en dehors de l'axe (YY) de serrage des empilements, les échangeurs (2-3, 102-103) adjacents d'une même nappe peuvent tourner l'un par rapport à l'autre autour de l'axe (XX) de leur conduit (10) de circulation, les thermoéléments et les échangeurs étant en contact selon l'axe (YY) de serrage des empilements, leurs contacts sur au moins une de leurs faces ayant un profil permettant une rotation par rapport à l'axe des conduits de circulation.

2. Installation thermoélectrique selon la revendication 1 caractérisée en ce que le profil de contact entre échangeurs (102-103) et thermoéléments (101) est un profil cylindrique d'axe parallèle à l'axe des conduits de circulation et passant par l'axe de serrage de l'empilement.

3. Installation thermoélectrique selon la revendication 1 caractérisée en ce que le profil de contact entre échangeurs (2-3) et thermoéléments (1) est un profil sphérique dont le centre est situé sur l'axe (YY) de serrage de l'empilement.

4. Installation thermoélectrique selon l'une quelconque des revendications 1 à 3 caractérisée en ce qu'elle comporte des échangeurs de chaleur (2-3, 102-103) formés d'une âme (8, 108) située en contact entre les thermoéléments (1, 101) et percée d'un conduit (10), décalé par rapport à l'axe (YY) de serrage des empilements, et de même axe (XX) que le conduit d'un échangeur de la colonne voisine, dans ces conduits, étant serti un tube (11) rigide, isolant électrique ou isolé électriquement des échangeurs, les échangeurs pouvant tourner, par rapport au tube, autour de l'axe (XX) des conduits (10).

5. Installation thermoélectrique selon la revendication 4 caractérisée en ce qu'un film isolant électrique (20) est interposé entre le tube (11) rigide conducteur électrique et les conduits (10) des échangeurs.

6. Installation thermoélectrique selon l'une quelconque des revendications 1 à 3 caractérisée en ce qu'elle comporte des échangeurs (2-3, 102-103) de chaleur formés d'une âme (8, 108), située en contact entre les thermoéléments (1, 101) et percée d'un conduit (10), décalé par rapport à l'axe (YY) de serrage des empilements, et de même axe (XX) que le conduit (10) d'un échangeur de la même nappe, les échangeurs étant emboîtés les uns dans les autres par leurs conduits.

7. Installation thermoélectrique selon la revendication 6 caractérisée en ce que le conduit (10) de chaque échangeur porte, d'un côté, un prolongement tubulaire (21) du conduit et, de l'autre, une chambre (22) circulaire interne au conduit pour l'emboîtement du prolongement tubulaire (21) de l'échangeur voisin.

8. Installation thermoélectrique selon l'une quelconque des revendications 1 à 7 caractérisée en ce que les thermoéléments (1, 101) ont la forme de pastilles à faces planes sur lesquelles sont rapportées des plaques dont l'une au moins a une face à profil permettant une rotation par rapport à l'axe des conduits de circulation.

9. Installation thermoélectrique selon l'une quelconque des revendications 1 à 7 caractérisée en ce que les thermoéléments sont des modules thermoélectriques sur lesquels sont rapportées des plaques dont l'une au moins a une face à profil permettant une rotation par rapport à l'axe des conduits de circulation.

10. Installation thermoélectrique selon la revendication 9 lorsqu'elle dépend de l'une quelconque des revendications 1 à 3 caractérisée en ce que les échangeurs d'une même nappe sont en une seule pièce, des zones amincies entre échangeurs permettant la rotation des échangeurs entre eux autour de l'axe des conduits de circulation.

**Claims**

1. Thermoelectric installation comprising thermoelements (1, 101) mounted between heat exchangers (2-3, 102-103), provided with a pipe (10) for the circulation of a hot fluid (C) or a cold fluid (F) and alternating with the thermoelements in order to form stacks or columns (4) arranged side by side in order to produce an arrangement or slide in which the thermoelements are located in parallel planes and the exchangers in facing relationship in the form of layers, defining two pipes for the circulation of fluids, one for the hot fluid, the other for the cold fluid, the constituent elements of each column being held together by clamping means (5), characterised in that the pipes (10) for the circulation of hot or cold fluids of the exchangers being situated outside the axis (YY) for the clamping of the piles, the adjacent exchangers (2-3, 102-103) of the same layer may turn one with respect to the other about the axis (XX) of their circulation pipe (10), the thermoelements and the exchangers being in contact along the axis (YY) for clamping of the piles, their contacts on at least one of their faces having a profile allowing a rotation with respect to the axis of the circulation pipes.

2. Thermoelectric installation according to Claim 1, characterised in that the profile of contact between the exchangers (102-103) and thermoelements (101) is a cylindrical profile on an axis parallel to the axis of the circulation pipes and passing through the clamping axis of the pile.

3. Thermoelectric installation according to Claim 1, characterised in that the profile of contact between exchangers (2-3) and thermoelements (1) is a spherical profile whereof the centre is situated on the axis (YY) for clamping of the pile.

4. Thermoelectric installation according to any one of Claims 1 to 3, characterised in that it comprises heat exchangers (2-3, 102-103) formed by a core (8, 108) situated in contact between the thermoelements (1, 101) and passing through which is a pipe (10), offset with respect to the axis (YY) for clamping of the piles and on the same axis (XX) as the pipe of an exchanger of the adjacent column, there being fitted in these pipes a rigid tube (11) which is electrically insulating or insulated electrically from the exchangers, the exchangers being able to turn, with respect to the tube, about the axis (XX) of the pipes (10).

5. Thermoelectric installation according to Claim 4, characterised in that an insulating electrical film (20) is interposed between the electrically conducting rigid tube (11) and the pipes (10) of the exchangers.

6. Thermoelectric installation according to one of Claims 1 to 3, characterised in that it comprises heat exchangers (2-3, 102-103) formed by a core (8, 108), situated in contact between the thermoelements (1, 101) and passing through which is a pipe (10), offset with respect to the axis (YY) for clamping the piles and on the same axis (XX) as the pipe (10) of an exchanger of the same layer, the exchangers being fitted one in the other by their pipes.

7. Thermoelectric installation according to Claim 6, characterised in that on one side the pipe (10) of each exchanger supports a tubular extension (21) of the pipe and on the other side a circular chamber (22) inside the pipe for the fitting of the tubular extension (21) of the adjacent exchanger.

8. Thermoelectric installation according to any one of Claims 1 to 7, characterised in that the thermoelements (1, 101) are in the shape of lozenges having flat faces to which are attached plates whereof at least one has a face with a profile allowing a rotation with respect to the axis of the circulation pipes.

9. Thermoelectric installation according to any one of Claims 1 to 7, characterised in that the thermoelements are thermoelectric modules to which are attached plates whereof at least one has a face with a profile allowing a rotation with respect to the axis of the circulation pipes.

10. Thermoelectric installation according to Claim 9, when it depends on one of Claims 1 to 3, characterised in that the exchangers ·of the same layer are in a single piece, thin areas between exchangers allowing the rotation of the exchangers with respect to each other about the axis of the circulation pipes.

## Patentansprüche

1. Thermoelektrische Anlage mit zwischen Wärmetauschern (2-3, 102-103) angeordneten Thermoelementen (1, 101), einer Rohrleitung (10) für ein warmes (C) oder ein kaltes (F) Fluid, die alternierend zu den Thermoelementen angeordnet ist, um Stapel oder Säulen (4) zu bilden, die derart nebeneinander angeordnet sind, daß sie eine Gesamtheit bilden, in der die Thermoelemente sich in parallelen Ebenen und die Wärmetauscher zueinander in Schichten angeordnet befinden, die zwei Fluidleitungsrohre, eines für das warme Fluid und das andere für das kalte Fluid, begrenzen, wobei die jede Säule bildenden Elemente mittels Klemmgliedern (5) zusammengehalten werden, dadurch gekennzeichnet, daß die Rohrleitungen (10) für das warme oder kalte Fluid des Wärmetauschers außerhalb der Achse (YY), in der die Stapel festgeklemmt werden, liegen, daß die an eine selbe Schicht angrenzenden Wärmetauscher (2-3, 102-103) zueinander um die Achse (XX) ihrer Rohrleitung (10) schwenkbar sind und daß die Thermoelemente und die Wärmetauscher längs der Achse (YY), längs der die Stapel geklemmt sind, miteinander in Kontakt stehen, wobei ihre Kontaktflächen auf mindestens einer ihrer Seiten ein Profil haben, das eine Drehung um die Achse der Rohrleitungen erlaubt.

2. Thermoelektrische Einrichtung nach Anspruch 1, dadurch gekennzeichnet, daß das Kontaktprofil zwischen den Wärmetauschern (102-103) und den Thermoelementen (101) ein Zylinderprofil mit einer zur Achse der Rohrleitungen parallelen Achse ist, die durch die Achse, längs der die Stapel geklemmt sind, verläuft.

3. Thermoelektrische Einrichtung nach Anspruch 1, dadurch gekennzeichnet, daß das Kontaktprofil zwischen den Wärmetauschern (2-3) und den Thermoelementen (1) ein sphärisches Profil ist, dessen Mittelpunkt auf der Achse (YY), längs der die Stapel geklemmt sind, liegt.

4. Thermoelektrische Einrichtung nach einem der Ansprüche 1-3, gekennzeichnet durch Wärmetauscher (2-3, 102-103), die aus einem Block (8, 108) bestehen, der zwischen den Thermoelementen (1, 101) liegt und mit diesem in Kontakt steht und durch den bezüglich der Achse (YY), längs der die Blockstapel geklemmt sind, versetzt eine Rohrleitung (10) verläuft, wobei die Rohrleitung (10) auf derselben Achse (XX), wie die Rohrleitung eines Wärmetauschers der benachbarten Säule liegt und wobei in diesen Rohrleitungen ein starres Rohr (11) eingefügt ist, das elektrisch isolierend ist oder gegenüber den Wärmetauschern elektrisch isoliert ist, und wobei die Wärmetauscher bezüglich des Rohrs um die Achse (XX) der Rohrleitungen (10) drehbar sind.

5. Thermoelektrische Einrichtung nach Anspruch 4, dadurch gekennzeichnet, daß ein elektrisch isolierender Film (20) zwischen dem starren, elektrisch leitenden Rohr (11) und den Rohrleitungen (10) der Wärmetauscher eingefügt ist.

6. Thermoelektrische Einrichtung nach einem der Ansprüche 1-3, gekennzeichnet durch Wärmetauscher (2-3, 102-103), die einen Block (8, 108) aufweisen, der zwischen den Thermoelementen (1, 101) und in Kontakt mit diesen angeordnet ist, durch den eine Rohrleitung (10), bezüglich der Achse (YY), längs der die Stapel geklemmt sind, versetzt verläuft und die auf derselben Achse (XX) wie die Rohrleitung (10) eines Wärmetauschers derselben Schicht liegt, wobei die Wärmetauscher längs ihrer Leitungen ineinander greifen.

7. Thermoelektrische Einrichtung nach Anspruch 6, dadurch gekennzeichnet, daß die Rohrleitung (10) eines jeden Wärmetauschers auf einer Seite eine rohrförmige Verlängerung (21) der Leitung und auf der anderen Seite eine innere kreisförmige Kammer (22) für die Leitung aufweist, um die rohrförmige Verlängerung (21) des benachbarten Wärmetauschers einzustecken.

8. Thermoelektrische Einrichtung nach einem der Ansprüche 1-7, dadurch gekennzeichnet, daß die Thermoelemente (1, 101) die Form von Tabletten mit ebenen Oberflächen haben, auf denen Platten angebracht sind, von denen mindestens eine eine Oberfläche mit einem Profil hat, das eine Drehung bezüglich der Achse der Rohrleitungen ermöglicht.

9. Thermoelektrische Einrichtung nach einem der Ansprüche 1-7, dadurch gekennzeichnet, daß die Thermoelemente thermoelektrische Module sind, auf denen Platten angebracht sind, von denen wenigstens eine ein Profil hat, das eine Drehung bezüglich der Rohrleitungen erlaubt.

10. Thermoelektrische Einrichtung nach Anspruch 9, sofern dieser auf einen der Ansprüche 1-3 rückbezogen ist, dadurch gekennzeichnet, daß die Wärmetauscher einer selben Schicht einstückig sind, wobei verjüngte Bereiche zwischen den Wärmetauschern eine Drehung der Wärmetauscher untereinander um die Achse der Rohrleitungen ermöglicht.

0 119 502

Fig 1

Fig. 2

Fig. 3

Fig. 4

Fig. 5

Fig. 6

4